# EUROPÄISCHE PATENTSCHRIFT

(11) **EP 2 159 821 B1**
(45) Veröffentlichungstag und Bekanntmachung des Hinweises auf die Patenterteilung: **15.01.2020**
(21) Anmeldenummer: 09161905.6
(22) Anmeldetag: 04.06.2009
(51) Int. Cl.: H01J 37/34, C23C 14/22, C23C 14/32, C23C 14/35, H01J 37/32

(54) **Beschichtungsvorrichtung zum Beschichten eines Substrats, sowie ein Verfahren zum Beschichten eines Substrats**
Coating device for coating a substrate and method for same
Dispositif de revêtement destiné au revêtement d'un substrat et procédé de revêtement d'un substrat

(30) Priorität: 02.09.2008 EP 08163508
(43) Veröffentlichungstag der Anmeldung: 03.03.2010
(73) Patentinhaber: Oerlikon Surface Solutions AG, Pfäffikon, 8808 Pfäffikon SZ (CH)
(72) Erfinder: Vetter, Jörg, Dr., 51469, Bergisch Gladbach (DE); Erkens, Georg, Dr., 52068, Aachen (DE)
(74) Vertreter: Intellectual Property Services GmbH

(56) Entgegenhaltungen:
- EP-A- 0 459 137
- EP-A1- 1 072 055
- EP-A1- 1 609 882
- EP-A1- 1 749 118
- EP-A1- 1 804 275
- EP-A2- 2 037 000
- WO-A-91/00374
- WO-A-02/070776
- DE-A1- 10 155 120
- JP-A- H1 129 866
- US-A1- 2004 007 455
- US-A1- 2006 000 705
- US-A1- 2006 182 999
- JILEK M ET AL: "Development of novel coating technology by vacuum arc with rotating cathodes for industrial production of nc-(Al1-xTix)N/a-Si3N4 superhard nanocomposite coatings for dry, hard machining", PLASMA CHEMISTRY AND PLASMA PROCESSING, KLUWER ACADEMIC PUBLISHERS-PLENUM PUBLISHERS, NE, vol. 24, no. 4, 1 December 2004 (2004-12-01), pages 493-510, XP019290251, ISSN: 1572-8986, DOI: 10.1007/S11090-004-7929-3
- CSELLE T: "LARC: NEUE, INDUSTRIELLE BESCHICHTUNGSTECHNOLOGIE", WERKSTATT + BETRIEB, CARL HANSER VERLAG, MÜNCHEN DE, vol. 136, no. 3, 1 March 2003 (2003-03-01) , pages 12,14-17, XP001145166, ISSN: 0043-2792

## Beschreibung

Die Erfindung betrifft eine Verdampfungsvorrichtung zur Verdampfung eines Targetmaterials, sowie ein Verfahren zum Beschichten eines Substrats gemäss dem Oberbegriff des unabhängigen Anspruchs der jeweiligen Kategorie.

Zum Aufbringen von Schichten oder Schichtsystemen auf die unterschiedlichsten Substrate sind aus dem Stand der Technik eine ganze Reihe verschiedener chemischer, mechanischer und physikalischer Techniken bekannt, die je nach Anforderung und Einsatzgebiet ihre Berechtigung haben und entsprechende Vor- und Nachteile aufweisen.

Zum Aufbringen verhältnismässig dünner Schichten sind insbesondere Verfahren geläufig, bei welchen die Oberfläche eines Targets in einem Lichtbogen in die Dampfform überführt wird oder aber aus einer Oberfläche eines Targets Atome mittels ionisierter Teilchen in die Dampfform überführt werden, wobei sich der so gebildete Dampf dann als Beschichtung auf einem Substrat niederschlagen kann.

In einer üblichen Ausführungsform der Kathodenzerstäubung wird in einem Sputterprozess das Target an eine negative Gleichstromspannungsquelle oder an eine hochfrequente Stromquelle angeschlossen. Das Substrat ist das zu beschichtende Material und es befindet sich zum Beispiel dem Target gegenüber. Das Substrat kann geerdet, schwimmend, vorgespannt, erhitzt, gekühlt sein oder einer Kombination hiervon unterworfen werden. In die Prozesskammer, die unter anderem die Prozesselektroden und das Substrat enthält, wird ein Prozessgas eingeführt, um eine Gasatmosphäre zu schaffen, in welchem eine Glimmentladung ausgelöst und aufrechterhalten werden kann. Die Gasdrücke reichen je nach Anwendung von wenigen Zehntel eines Pascals) bis zu mehreren Pascals. Ein häufig verwendetes Zerstäubergas ist Argon.

Wenn die Glimmentladung ausgelöst wird, treffen positive Ionen auf die Oberfläche des Targets und lösen hauptsächlich neutrale Targetatome durch Stoßkraftübertragung heraus, und diese kondensieren auf dem Substrat, um dünne Filme zu bilden. Es gibt zusätzlich noch andere Partikel und Strahlungen, die durch das Target erzeugt werden und alle filmbildende Eigenschaften haben (Sekundärelektronen und Ionen, desorbierte Gase, und Photonen). Die Elektronen und negativen Ionen werden gegen die Substratplattform beschleunigt und bombardieren diese und den wachsenden Film. In einigen Fällen wird ein zum Beispiel negatives Vorspannungspotential an den Substrathalter gelegt, so daß der wachsende Film dem Beschuss mit positiven Ionen ausgesetzt ist. Dieser Prozess ist auch als Vorspannungszerstäubung oder Ionenplattierung bekannt.

In bestimmten Fällen werden keine Argon-, sondern andere Gase oder Gasmischungen verwendet. Das schließt gewöhnlich einige Arten von Reaktionszerstäuberprozessen ein, in welchen eine Zusammensetzung durch Aufstäuben eines Metalltargets (z. B.Ti) in einem zumindest zum Teil reaktiven Reaktionsgas synthetisiert wird, um eine Zusammensetzung aus dem Metall und den Reaktionsgasarten (z.B. Titanoxide) zu bilden. Der Zerstäubungsertrag wird definiert als Zahl der aus der Targetoberfläche ausgestoßenen Atome pro einfallendem Ion. Es ist ein wesentlicher Parameter zur Charakterisierung des Zerstäuberprozesses.

Schätzungsweise ein Prozent der auf eine Targetoberfläche einfallenden Energie führt gewöhnlich zum Ausstoßen zerstäubter Partikel, 75 % der einfallender Energie führen zur Erwärmung des Target und der Rest wird zum Beispiel durch sekundäre Elektronen zerstreut, die das Substrat bombardieren und erhitzen können. Ein als Magnetron-Zerstäubung bekannter verbesserter Prozeß verwendet magnetische Felder zur Führung der Elektronen weg von der Substratoberfläche, wodurch die Wärmeeinwirkung reduziert wird.

Für ein gegebenes Targetmaterial werden die Auftragsrate und die Gleichmäßigkeit unter anderem durch die Systemgeometrie, die Targetspannung, das Zerstäubergas, den Gasdruck und die and die Prozesselektroden angelegte elektrische Leistung beeinflußt.

Ein verwandtes physikalisches Beschichtungsverfahren ist das bekannte Lichtbogenverdampfung in seinen vielfältigen Ausgestaltungen.

Bei der Lichtbogenverdampfung wird das Target-Material durch die Wirkung von Vakuumlichtbögen verdampft. Das Targetquellenmaterial ist die Kathode in dem Lichtbogenkreis. Die Grundkomponenten eines bekannten Lichtbogenverdampfungssystems bestehen aus einer Vakuumkammer, einer Kathode und einem Lichtbogenstromanschluß, Teilen zum Zünden eines Lichtbogens auf der Kathodenoberfläche, einer Anode, einem Substrat und aus einem Stromanschluß für eine Substratvorspannung. Die Lichtbögen werden durch Spannungen im Bereich von zum Beispiel 15-50 Volt gehalten, abhängig von dem Targetkathodenmaterial, das verwendet wird. Typische Lichtbogenströme liegen im Bereich von 30-400 A. Die Lichtbogenzündung erfolgt durch die übleichen dem Fachmann bekannten Zündverfahren.

Die Verdampfung des Targetmaterials aus der Kathode, die das Target bildet, ergibt sich als Resultat eines kathodischen Lichtbogenpunktes, der sich im einfachsten Fall regellos auf der Kathodenfläche mit Geschwindigkeiten von üblicherweise 10 m/s bewegt. Die Lichtbogenpunktbewegung kann dabei aber auch mit Hilfe geeigneter Einschlußabgrenzungen und / oder magnetischer Felder gesteuert werden. Das Target-Kathodenmaterial kann zum Beispiel ein Metall oder eine Metalllegierung sein.

Der Lichtbogenbeschichtungsprozess ist erheblich verschieden von anderen physikalischen Dampfbeschichtungsprozessen. Der Kern der bekannten Lichtbogenprozesse ist der Lichtbogenpunkt, der ein Materialplasma erzeugt. Ein hoher Prozentsatz, z.B. 30 % - 100 % des von der Kathodenfläche verdampften Materials ist in der Regel ionisiert, wobei die Ionen in verschiedenen Ladungszuständen im Plasma, beispielsweise als Ti+, Ti2+, Ti3+ usw. existieren können. Die kinetische Energie der Ionen kann sich dabei im Bereich von z.B. 10- 100 e.V bewegen.

Diese Merkmale führen zu Beschichtungen, die von höchster Qualität sein können, und verglichen mit jenen Beschichtungen, die mit von anderen physikalischen Dampfbeschichtungsprozessen aufgetragen werden, bestimmte Vorteile aufweisen können.

Die mittels Lichtbogenverdampfung aufgetragene Schichten zeigen meist über einen breiten Bereich der Beschichtungsbedingungen eine hohe Qualität. So lassen sich z. B. stöchiometrische Verbundfilme mit höchster Adhäsion und hoher Dichte herstellen, die über einen weiten Bereich des Reaktionsgasdruckes hohe Beschichtungsbeträge für Metalle, Legierungen und Zusammensetzungen mit exzellenter Beschichtungsgleichmäßigkeit liefern. Neben anderen ist ein weiterer Vorteil auch die verhältnismässig niedrigen Substrattemperaturen und die relativ einfache Herstellung von Verbundfilmen.

Der kathodische Lichtbogen führt zu einer Plasmaentladung innerhalb des von der Kathodenfläche freigesetzten Materialdampfes. Der Lichtbogenpunkt ist normalerweise einige Mikrometer groß und hat Stromdichten von 10 Ampere pro Quadratmikrometer. Diese hohe Stromdichte verursacht eine blitzartige Verdampfung des Ausgangsmaterials, und der erzeugte Dampf besteht aus Elektronen, Ionen, neutralen Dampfatomen und Mikrotröpfchen. Die Elektronen werden gegen die Wolken positiver Ionen beschleunigt. Die Emissionen des Kathodenlichtpunkts sind über einen breiten Bereich des Lichtbogenstromes relativ konstant, wenn der Kathodenpunkt in mehrere Punkte aufgeteilt wird. Der Durchschnittsstrom pro Punkt hängt von der Natur des Kathodenmaterials ab.

Oft sind fast 100 % des Materials innerhalb der Kathodenpunktregion ionisiert. Diese Ionen werden in eine Richtung fast senkrecht zur Kathodenfläche herausgeschleudert. Darüber hinaus entstehen in der Regel Mikrotröpfchen die gezwungen sind, die Kathodenfläche unter Winkeln von zum Beispiel bis zu 30 % oberhalb der Kathodenebene zu verlassen. Diese Mikrotröpfchenemissionen sind eine Folge extremer Temperaturen und Kräfte, die innerhalb des Emissionskraters vorhanden sind.

Daher wird die kathodische Lichtbogenplasmabeschichtung auch heute noch oft als ungeeignet für dekorative Verwendungen angesehen, und zwar wegen der Mikrotröpfchen in dem Film.

Die letzten Entwicklungen, welche die Eliminierung von Mikrotröpfchen im Lichtbogenbeschichtungsprozess einschließen haben eine bedeutende Alternative zu existierenden Techniken für einen breiten Bereich auch, aber nicht nur für dekorative Anwendungen geschaffen.

Dabei zeichnen sich die bekannten Lichtbogenprozesse auch durch eine hohe Flexibilität aus. So ist beispielweise Die Steuerung der Beschichtungsparameter weniger kritisch als bei Magnetronzerstäubungs- oder lonenplattierungsprozessen.

Die Beschichtungstemperatur für Verbundfilme kann auf deutlich tiefere Temperaturen eingestellt werden, so dass die Möglichkeit gegeben ist, Substrate zu ummanteln, wie zum Beispiel Zinkguss, Messing und Kunststoffe, ohne das Substrat zu schmelzen.

Zusammenfassend bieten die bekannten Lichtbogen Beschichtungsprozesse unter bestimmten Umständen eine Reihe von Vorteile gegenüber den oben erwähnten Zerstäubungsprozesssen mittels Sputtern.

Dennoch werden zahlreiche Beschichtungen, vor allem aber nicht nur für dekorative Anwendungen bzw. Anwendungen in der Mikroelektronik, der Optik oder anderen Anwendungen, die einen dünnen Film erfordern, bevorzugt mit einem Zerstäubungsprozess ausgeführt. Für das Sputtern bevorzugte Materialien sind z.B. Sulfide (z.B. MoS₂) oder auch spröde Materialien (z.B. TiB₂). Letztlich im Grunde alle Materialien die beschränkt arc-fähig sind.

Das hängt unter anderem von den Problemen ab, die erwähnten Mikrotröpfchen zu eliminieren. Deshalb ist die Zerstäubung heutzutage immer noch das bevorzugte Verfahren um beispielweise einen dünnen Goldmantel für dekorative Zwecke, oder dünne Schichten in der Elektronik oder Optik aufzutragen. Of haben die durch die Zerstäubungsprozesse aufgetragen Schichten aber andere unerwünschte Eigenschaften, zum Beispiel in Bezug auf Alterung, Härte, Haftfestigkeit oder sie haben Defizite in Bezug auf die Resistenz gegen verschiedene Einflüsse von aussen und können so beeinträchtigt oder gar abgetragen werden.

Deshalb kann es je nach Anforderung vorteilhaft sein, eine Kombination von Schichten auf einem Substrat bereitzustellen, wobei eine der Schichten z.B. eine durch Sputtern aufgebrachte Schicht ist und eine andere Schicht eine durch ein Lichtbogenverfahren aufgebrachte Schicht ist.

Zur Herstellung dekorativer Goldbeschichtungen ist in der WO 90/02216 eine Beschichtungsanlage angegeben, die gleichzeitig eine konventionelle rechteckige Sputterquelle und eine rechteckige kathodische Lichtbogenverdampfungsquelle umfasst. Eine ähnliche Anordnung, die gleichzeitig eine konventionelle rechteckige Sputterquelle und eine rechteckige kathodische Lichtbogenverdampfungsquelle umfasst, ist in der WO 91/00374 offenbart. Gemäss dem in der WO 90/02216 ebenfalls angegebenen Verfahren wird in einem ersten Verfahrensschritt in einem kathodischen Lichtbogenverfahren eine Schicht aus TiN aufgetragen, wobei in einem nachfolgenden Schritt mittels eines Sputterverfahrens eine Gold Schicht aufgesputtert wird, so dass das Schichtsystem insgesamt ein im wesentlichen gleiches Aussehen wie ein einfache Beschichtung aus Gold alleine vermittelt.

Ein Nachteil der Beschichtungsanlage und des Verfahrens gemäss WO 90/02216 besteht unter anderem darin, dass insbesondere eine gleichbleibende Qualität der Beschichtungen nicht gewährleistet ist. So ändert sich mit zunehmendem Verbrauch der Kathoden die Qualität der aufgebrachten Schichten, wenn nicht die Verfahrensparameter aufwendig nachgeführt werden. Das liegt unter bekanntermassen anderem daran, dass sich die rechteckigen Kathoden ungleichmässig verbrauchen, so dass bei gleichen Verfahrensparametern mit zunehmender Erosion der Kathoden die Qualität des Beschichtungsdampfes zunehmend schlechter wird, weil sich z.B. in zunehmendem Masse störende Tröpfchen beim Lichtbogenverdampfen bilden, was sich negativ auf die Schichten auswirkt. Um diese negativen Effekte in Grenzen zu halten, müssen die Kathoden frühzeitig ausgetauscht werden, was entsprechend teuer und aufwändig ist.

Ein weiterer Nachteil neben der ungleichmässigen Erosion der Kathoden ist, dass eine Steuerung des Lichtbogens auf der Kathode, sofern überhaupt möglich, sehr schwierig und aufwendig ist.

Auch müssen zwingend eine Kathode zum Zerstäuben und eine zweite separate Kathode zum Lichtbogenverdampfen vorgesehen werden, weil selbst dann, wenn eine runde oder rechteckige Kombinationskathode verwendet wird, die zum Beispiel in zwei verschiedenen Bereichen mit verschiedenen Materialien versehen ist, nicht ein und dieselbe Kathode zum Sputtern und Lichtbogenbeschichten verwendet werden kann.

Aufgabe der Erfindung ist es daher, eine verbesserte Beschichtungsvorrichtung und ein Verfahren zum Beschichten vorzuschlagen mit welchem ein Substrat in ein und derselben Beschichtungskammer weitgehend defektfrei sowohl durch Lichtbogenverdampfung als auch mittels eines Sputterverfahrens beschichtet werden können, insbesondere, aber nicht zwingend auch mit verschiedenen Materialien, so dass insbesondere Kombinationsschichtsysteme, die allerhöchsten Qualitätsanforderungen genügen, einfach und kostengünstig herstellbar sind.

Die diese Aufgaben in apparativer und verfahrenstechnischer Hinsicht lösenden Gegenstände der Erfindung sind durch die Merkmale des unabhängigen Anspruchs der jeweiligen Kategorie gekennzeichnet.

Die abhängigen Ansprüche beziehen sich auf besonders vorteilhafte Ausführungsformen der Erfindung.

Die Erfindung betrifft somit eine Verdampfungsvorrichtung zur Verdampfung eines Targetmaterials. Die Verdampfungsvorrichtung umfasst eine Prozesskammer zur Errichtung und Aufrechterhaltung einer Gasatmosphäre, die einen Einlass und einen Auslass für ein Prozessgas aufweist, sowie eine Anode und eine als Target ausgestaltete zylinderförmige Verdampfungskathode, welche zylinderförmige Verdampfungskathode das Targetmaterial umfasst. Weiter ist eine elektrische Energiequelle zur Erzeugung einer elektrischen Spannung zwischen der Anode und der Kathode vorgesehen, so dass mittels der elektrischen Energiequelle das Targetmaterial der zylinderförmigen Kathode in eine Dampfphase überführbar ist, wobei eine ein Magnetfeld erzeugende Magnetfeldquelle vorgesehen ist. Dabei ist in der Prozesskammer gleichzeitig eine Zerstäubungskathode und eine Lichtbogenkathode vorgesehen. Erfindungsgemäss ist die Zerstäubungskathode eine zylinderförmige Zerstäubungskathode und die Lichtbogenkathode eine zylinderförmige Lichtbogenkathode und eine Position der Magnetfeldquelle ist im Inneren der zylinderförmigen Zerstäubungskathode und / oder im Inneren der zylinderförmigen Lichtbogenkathode in Bezug auf eine Umfangsrichtung einstellbar. Durch die Erfindung ist es somit möglich, eine Kombination von Schichten auf einem Substrat bereitzustellen, wobei eine der Schichten z.B. eine durch Sputtern aufgebrachte Schicht ist und eine andere Schicht eine durch ein Lichtbogenverfahren aufgebrachte Schicht ist.

Dabei werden durch die Erfindung die aus dem Stand der Technik bekannten Nachteile, wie sie zum Beispiel bei der Beschichtungsanlage und dem Verfahren gemäss WO 90/02216 bestehen, vermieden. Durch die vorliegende Erfindung ist es erstmals möglich, insbesondere eine gleichbleibende Qualität der Beschichtungen zu gewährleisten. So ändert sich mit zunehmendem Verbrauch der Kathoden die Qualität der aufgebrachten Schichten nicht, und die Verfahrensparameter müssen nicht aufwendig nachgeführt werden. Das liegt unter anderem daran, dass sich die erfindungsgemässen Kathoden gleichmässig verbrauchen, so dass bei gleichen Verfahrensparametern mit zunehmender Erosion der Kathoden die Qualität des Beschichtungsdampfes gleich bleibt und nicht deshalb schlechter wird, weil sich z.B. in zunehmendem Masse störende Tröpfchen beim Lichtbogenverdampfen bilden, was sich negativ auf die Schichten auswirkt. Da bei der vorliegenden Erfindung diese negativen Effekte praktisch nicht mehr auftreten, müssen die Kathoden nicht wie im Stand der Technik frühzeitig ausgetauscht werden, was zu entsprechenden bedeutenden Kosteneinsparungen führt.

Auch ist die Steuerung des Lichtbogens auf der Kathode aufgrund der zylindrischen Form der Kathoden und der Flexibilität der Anordnung der Magnetfeldquellen besonders einfach und flexibel.

Auch muss nicht mehr zwingend eine Kathode zum Zerstäuben und eine zweite separate Kathode zum Lichtbogenverdampfen vorgesehen werden, weil bei geeigneter Ausgestaltung der Verdampfungskathode, ein und dieselbe Verdampfungskathode zum Sputtern und zum Lichtbogenbeschichten verwendet werden kann.

Somit wird durch die Erfindung eine verbesserte Beschichtungsvorrichtung und ein verbessertes Verfahren zum Beschichten vorzuschlagen mit welchem ein Substrat in ein und derselben Beschichtungskammer weitgehend defektfrei sowohl durch Lichtbogenverdampfung als auch mittels eines Sputterverfahrens beschichtet werden kann, insbesondere, aber nicht zwingend auch mit verschiedenen Materialien, so dass insbesondere Kombinationsschichtsysteme, die allerhöchsten Qualitätsanforderungen genügen, einfach und kostengünstig herstellbar sind.

Dabei ist die erfindungsgemässe Beschichtungsvorrichtung und das erfindungsgemässe Verfahren sehr universell und flexibel einsetzbar. So können so verschiedene Objekte wie zum Beispiel Werkzeuge, hoch belastete Maschinenteile, dekorative Oberflächen unter anderem beschichtet werden. Aber auch im Bereich der Optik, der Mikromechanik, der Mikroelektronik, z.B. in der Medizintechnik und / oder zur Beschichtung von Elementen der Nanosensorik oder für Nanomotoren kann die Erfindung besonders vorteilhaft eingesetzt werden.

In einem speziellen Ausführungsbeispiel ist die zylinderförmige Zerstäubungskathode und / oder die zylinderförmige Lichtbogenkathode um eine Längsachse drehbar ausgestaltet.

Dabei ist die Magnetfeldquelle bevorzugt in einem Inneren der zylinderförmigen Zerstäubungskathode und / oder in einem Inneren der zylinderförmigen Lichtbogenkathode vorgesehen, und / oder die zylinderförmige Zerstäubungskathode und / oder die zylinderförmige Lichtbogenkathode ist relativ zur Magnetfeldquelle drehbar angeordnet.

Die Magnetfeldquelle ist vorteilhaft ein Permanentmagnet und / oder ein Elektromagnet, wobei eine Position der Magnetfeldquelle im Inneren der zylinderförmigen Zerstäubungskathode und / oder im Inneren der zylinderförmigen Lichtbogenkathode, insbesondere in Bezug auf eine axiale Position und / oder eine radiale Position und / oder in Bezug auf eine Umfangsrichtung einstellbar ist.

Es versteht sich, dass im Speziellen eine Stärke des Magnetfeldes der Magnetfeldquelle steuerbar und / oder regelbar ist, wobei die Magnetfeldquelle bevorzugt derart vorgesehen und angeordnet ist, dass in einem vorgebbaren Bereich der zylinderförmigen Verdampfungskathode eine Magnetfeldstärke des Magnetfeldes veränderbar ist,
Als Zerstäubungskathode kommt zum Beispiel ein balanciertes Magnetron und / oder ein unbalanciertes Magnetron in Frage.

Erfindungsgemäss wird dieselbe Verdampfungskathode derart ausgestaltet und in der Prozesskammer angeordnet, so dass die Verdampfungskathode sowohl als Zerstäubungskathode, als auch als Lichtbogenkathode verwendbar ist.

Die Erfindung betrifft weiter ein Verfahren zum Beschichten eines Substrats in einer Prozesskammer, in welcher Prozesskammer eine Gasatmosphäre errichtet und aufrechterhalten wird. In der Prozesskammer wird eine Anode und eine als Target ausgestaltete zylinderförmige Verdampfungskathode bereitgestellt, welche zylinderförmige Verdampfungskathode das Targetmaterial umfasst. Mittels einer elektrischen Energiequelle wird das Targetmaterial der zylinderförmigen Kathode in eine Dampfphase überführt, wobei eine ein Magnetfeld erzeugende Magnetfeldquelle derart in der Prozesskammer vorgesehen wird, dass in einem vorgegebenen Bereich der zylinderförmigen Verdampfungskathode eine Magnetfeldstärke des Magnetfeldes verändert werden kann. wird in der Prozesskammer gleichzeitig eine Zerstäubungskathode und eine Lichtbogenkathode vorgesehen, und das Substrat wird mit einem Lichtbogenverdampfungsverfahren und / oder einem Kathodenzerstäubungsverfahren beschichtet. Erfindungsgemäss ist die Zerstäubungskathode eine zylinderförmige Zerstäubungskathode und die Lichtbogenkathode eine zylinderförmige Lichtbogenkathode und eine Position der Magnetfeldquelle im Inneren der zylinderförmigen Zerstäubungskathode und / oder im Inneren der zylinderförmigen Lichtbogenkathode, wird in Bezug auf eine Umfangsrichtung eingestellt.

Bevorzugt wird die zylinderförmige Verdampfungskathode zur gleichmässigen Ausnutzung des Targetmaterials während eines Beschichtungsvorgangs um eine Längsachse rotiert.

Dabei kann in einem speziellen Ausführungsbeispiel eine Position der Magnetfeldquelle in einem Inneren der zylinderförmigen Zerstäubungskathode und / oder in einem Inneren der zylinderförmigen Lichtbogenkathode, insbesondere in Bezug auf eine axiale Position und / oder eine radiale Position und / oder in Bezug auf eine Umfangsrichtung eingestellt werden, wobei bevorzugt eine Stärke des Magnetfeldes der Magnetfeldquelle gesteuert und / oder geregelt wird.

Erfindungsgemäss kann ein und dieselbe Verdampfungskathode als Zerstäubungskathode und als Lichtbogenkathode verwendet werden. Vorteilhaft kann als Zerstäubungskathode ein balanciertes Magnetron und / oder ein unbalanciertes Magnetron verwendet werden.

Das Beschichtungsverfahren kann dabei ein DC-Sputterverfahren und / oder ein RF-Sputterverfahren und / oder ein gepulstes Sputterverfahren und / oder ein High-Power-Sputterverfahren und / oder ein DC-Lichtbogenverdampfungsverfahren und / oder ein gepulstes Lichtbogenverdampfungsverfahren und / oder ein anderes mir der erfindungsgemässen Verdampfungsvorrichtung durchführbares Beschichtungsverfahren sein.

Die Erfindung wird im Folgenden an Hand der schematischen Zeichnung näher erläutert. Es zeigen:
- Fig. 1: ein einfaches Ausführungsbeispiel einer erfindungsgemässen Verdampfungsvorrichtung;
- Fig. 2: ein erstes Ausführungsbeispiel einer Verdampfungskathode mit Permanentmagnetfeldquelle;
- Fig. 3: ein zweites Ausführungsbeispiel gemäss Fig. 2;
- Fig. 4: eine Magnetfeldquelle mit zentraler Spulenwicklung;
- Fig. 5: eine Magnetfeldquelle mit zwei getrennten Spulenwicklungen;

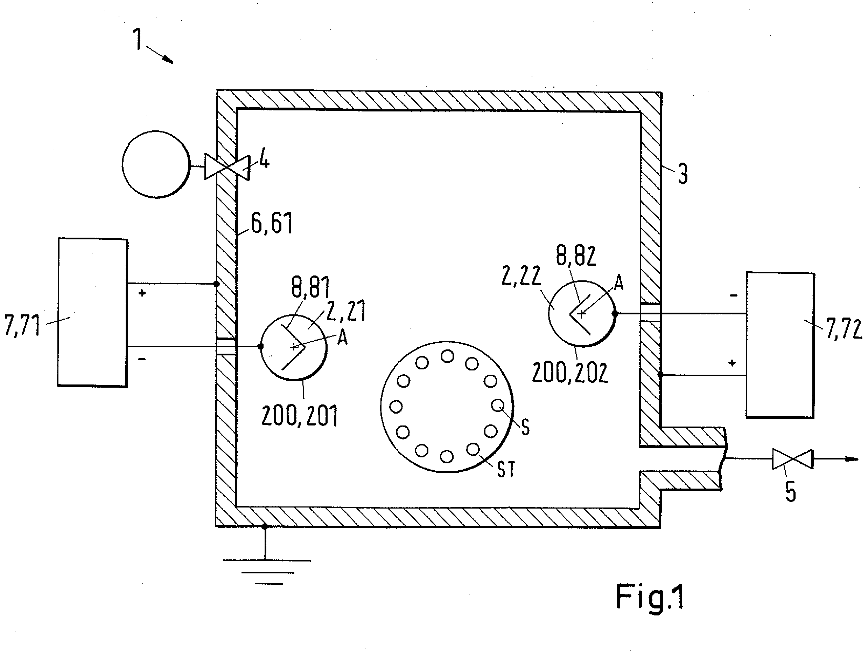

Fig. 1 zeigt in einer schematischen Darstellung ein einfaches Ausführungsbeispiel einer erfindungsgemässen Verdampfungsvorrichtung 1 zur Verdampfung eines Targetmaterials 200, 201, 202. Die Verdampfungsvorrichtung 1 umfasst eine Prozesskammer 3 zur Errichtung und Aufrechterhaltung einer Gasatmosphäre, die einen Einlass 4 und einen Auslass 5 für ein Prozessgas aufweist. In der Prozesskammer 3 ist eine Anode 6, 61 für die zylinderförmige Zerstäubungskathode 2, 21 vorgesehen, wobei im vorliegenden Beispiel der Fig. 1 die der Zerstäubungskathode 21 zugeordnete Anode 61 durch die Kammerwand der Prozesskammer 3 gebildet ist. Die Anode 61 und die Zerstäubungskathode 21 sind mit einer elektrischen Energiequelle 7, 71 zur Versorgung mit elektrischer Energie verbunden.

Beide zylindrischen Verdampfungskathoden 2, 21, 22 umfassen je eine ein Magnetfeld erzeugende Magnetfeldquelle 8, 81, 82 die derart vorgesehen sind, dass in einem vorgebbaren Bereich der zylinderförmigen Verdampfungskathode 2, 21, 22 eine Magnetfeldstärke des Magnetfeldes veränderbar ist. Das wird im vorliegenden Beispiel der Fig. 1 dadurch erreicht, dass die Magnetfeldquellen 8, 81, 82 im Inneren der zylindrischen Verdampfungskathoden 2, 21, 22 vorgesehen sind und in Bezug auf eine Rotation der Verdampfungskathoden 2, 21, 22, die im Betriebszustand um die Längsachse A gedreht werden, in Umfangsrichtung ortsfest sind, jedoch in Längsrichtung entlang der Längsachse A verschiebbar sind, so dass die Magnetfeldquellen 8, 81, 82 je nach Bedarf aus der zylindrischen Zerstäubungskathode 21 und / oder aus der zylindrischen Beschichtungskathode entfernt werden können.

In einem anderen Ausführungsbeispiel ist es auch möglich, dass die Magnetfeldquellen 8, 81, 82 in an sich bekannter Weise als sogenannte "virtuelle Shutter" fungieren, indem durch Verdrehen der Magnetfeldquelle 8, 81, 82 in Umfangsrichtung um die Zylinderachse A das Magnetfeld an der Oberfläche der zylindrischen Verdampfungsquelle 2, 21, 22 im wesentlichen z.B. in Richtung zur Kammerwand verdreht, so dass verdampftes Targetmaterial 200, 201, 202 die Oberfläche des Substrates nicht mehr erreicht.

Es versteht sich, dass in einem anderen Ausführungsbeispiel die Stärke des Magnetfeldes an der Verdampfungskathode 2, 21, 22 auch dadurch beeinflusst werden kann, dass zum Beispiel anstatt von Permanentmagneten 8, 81, 82 in der Verdampfungskathode 2, 21, 22 Elektromagnete 8, 81, 82 vorteilhaft vorgesehen werden können, deren Stärke und Richtung durch geeignete Einstellung eines elektrischen Stromes durch die Spulen der Elektromagnete 8, 81, 82 eingestellt werden kann.

Oder die Magnetfeldquelle 8, 81, 82 kann, wie erwähnt, auch selbst um die Längsachse A der Verdampfungskathode 2, 21, 22 drehbar sein, so dass zum Beispiel durch geeignete Rotation der Magnetfeldquelle 8, 81, 82 eine vom Magnetfeld beaufschlagte Fläche in einem ersten Betriebszustand in Richtung zum Substratteller ST gerichtet ist, auf welchem bevorzugt eine Vielzahl von zu beschichtenden Substraten S angeordnet sind, so dass diese in optimaler Weise durch das von der Verdampfungskathode 2, 21, 22 verdampfte Targetmaterial 200, 201, 202 beschichtet werden. Wobei in einem zweiten Betriebszustand die Magnetfeldquelle 8, 81, 82 im Inneren der Verdampfungskathode 2, 21, 22 derart um die Längsachse A gedreht wird, dass die vom Magnetfeld beaufschlagte Fläche der Verdampfungskathode 2, 21, 22 zum Beispiel auf die Kammerwand der Prozesskammer 3 gerichtet ist, so dass sich das verdampfte Targetmaterial 200, 201, 202 im wesentlichen auf der Kammerwand der Prozesskammer 3 abscheidet und so das Substart S im wesentlichen nicht mehr von der entsprechenden Verdampfungsquelle 2, 21, 22 beschichtet wird.

Es versteht sich, dass sich die zuvor beschrieben Massnahmen zur Beeinflussung und Veränderung des Magnetfeldes an der Oberfläche der Verdampferkathode 2, 21, 22 auch in geeigneter Weise vorteilhaft kombinieren lassen.

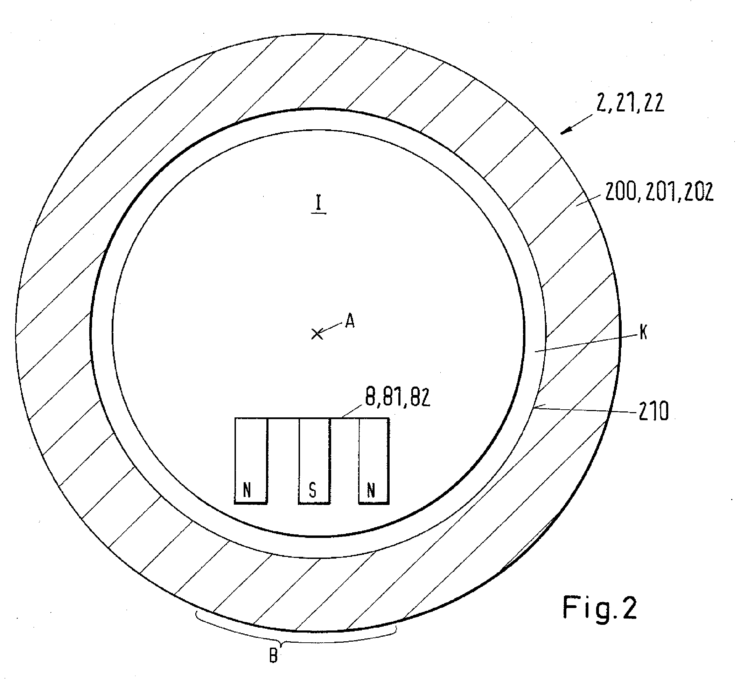

Fig. 2 zeigt etwas detaillierter ein erstes Ausführungsbeispiel einer Verdampfungskathode 2, 21, 22 mit Permanentmagnetfeldquelle 8, 81, 82. Die Verdampfungskathode 2, 21 ,22 der Fig. 2, die zum Beispiel eine Zerstäubungskathode 21 oder eine Lichtbogenkathode 22 sein kann, trägt auf einer äusseren Zylinderoberfläche 210 das Targetmaterial 200, 201, 202 mit dem ein Substart S beschichtet werden soll. So kann z.B. in ein und derselben Prozesskammer 3 die Zerstäubungskathode21 mit einem anderen Targetmaterial 200, 201 ausgestattet sein, als die Lichtbogenkathode 22, die ein anderes Targetmaterial 200, 202 umfasst, so dass insbesondere komplizierte Kombinationsschichtsysteme herstellbar sind. Selbstverständlich können die Zerstäubungskathode 21 und die Lichtbogenkathode 22 auch mit dem gleichen Targetmaterial 200, 201, 202 ausgestattet sein.

In bestimmten Fällen ist es sogar möglich, dass verschiedene Bereiche der Zerstäubungskathode 21 und / oder der Lichtbogenkathode 22 mit unterschiedlichen Targetmaterialien 200, 201, 202, so dass durch geeignete Steuerung und / oder Regelung des Lichtbogens unterschiedliche Beschichtungen bzw. Teilbeschichtungen aufgebracht werden können.

Zwischen dem hohlen Inneren I und der Zylinderoberfläche 210 ist ein Kühlungsspalt K vorgesehen, durch den ein Kühlmittel, z.B. Kühlwasser im Betriebszustand zirkuliert wird, das die Verdampfungskathode 2, 21, 22 im Betriebszustand kühlt. Das Targetmaterial 200, 201, 202 wird dabei im wesentlichen im Bereich B verdampft, da das von der Magnetfeldquelle 8, 81, 82 erzeugte Magnetfeld den Lichtbogen bzw. die Sputterionen zum Verdampfen des Targetmaterials 200, 201, 202 auf den Bereich B konzentriert.

Damit das Targetmaterial 200, 201, 202 über die Oberfläche der Verdampfungskathode 2, 21, 22 gleichmässig abgetragen wird, rotiert die Verdampfungskathode 2, 21, 22 im Betriebszustand um die Längsachse A, während die Magnetfeldquelle nicht rotiert, so dass der Bereich B gemäss dieser Rotation in Umfangsrichtung über die Oberfläche der Verdampfungskathode 2, 21, 22 wandert.

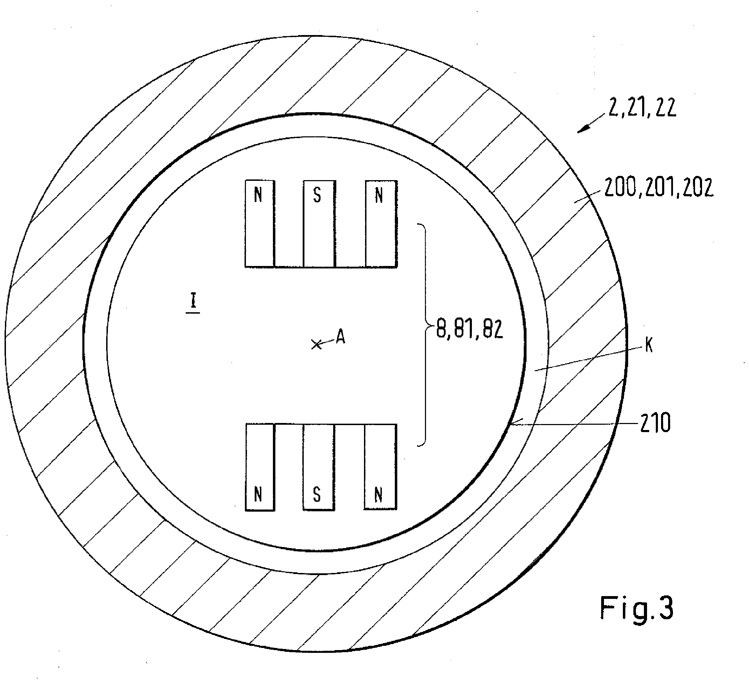

Fig. 3 zeigt ein zweites Ausführungsbeispiel einer Verdampfungskathode 2, 21, 22 mit Permanentmagnetfeldquelle 8, 81, 82. Das Beispiel der Fig. 3 unterscheidet sich von demjenigen der Fig. 2 dadurch, dass eine zusätzliche Magnetfeldquelle 8, 81, 82 vorgesehen ist. Dadurch kann z.B. durch geeignete räumliche Anordnung der Verdampfungskathode 2, 21, 22 und / oder durch geeignete Ausrichtung der Magnetfeldquelle 8, 81, 82 in den beiden entsprechenden Bereichen auf der Verdampfungskathode gleichzeitig Targetmaterial 200, 201, 202 verdampft werden. Es ist sogar möglich, dass auf ein und derselben Verdampfungskathode 2, 21, 22 in den beiden verschiedenen Oberflächenbereichen, die den Magnetfeldquellen, 8, 81, 82 zugeordnet sind, verschiedene Targetmaterialien 200, 201, 202 vorgesehen sind, so dass mit ein und derselben Verdampfungskathode gleichzeitig oder nacheinander verschiedene Beschichtungen auf das Substrat S aufgedampft werden können.

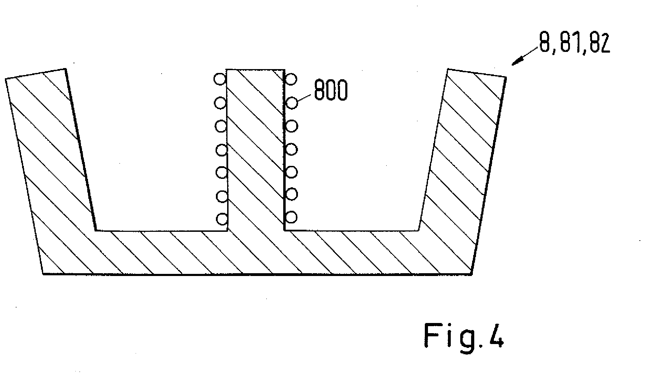

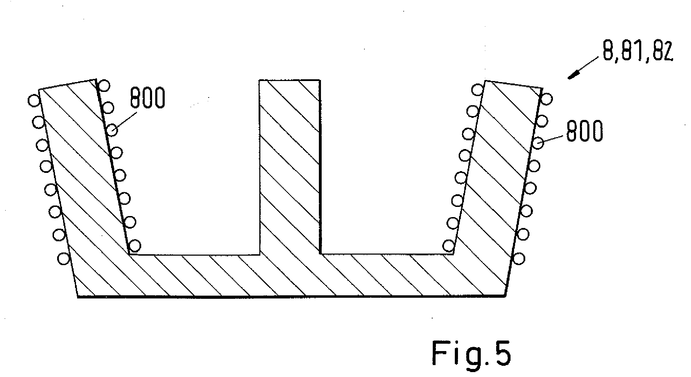

Wie bereits erwähnt, kann die Magnetfeldquelle 8, 81, 82 auch zum Beispiel vorteilhaft durch Elektromagnete 8, 81, 82 realisiert sein. Zwei spezielle Ausführungsbeispiele zeigen die Fig. 4 mit einer zentralen Spulenwicklung 800 und die Fig. 5 mit zwei getrennten äusseren Spulenwicklungen 800. Es versteht sich, dass je nach Ausgestaltung und Anordnung der Spulenwicklungen 800 je nach Anforderung spezielle Magnetfeldgeometrien erzeugt werden können.

Der Fachmann weiss wie entsprechende Anordnungen im speziellen Anwendungsfall zu wählen sind und kennt darüber hinaus noch eine Reihe weitere Magnetfeldkonfigurationen, die von den exemplarischen Beispielen der Fig. 2 bis Fig. 5 verschieden sind.

## Patentansprüche

1. Verdampfungsvorrichtung zur Verdampfung eines Targetmaterials (200, 201, 202), umfassend eine Prozesskammer (3) zur Errichtung und Aufrechterhaltung einer Gasatmosphäre, die einen Einlass (4) und einen Auslass (5) für ein Prozessgas aufweist, sowie eine Anode (6, 61) und eine als Target (2, 21, 22) ausgestaltete zylinderförmige Verdampfungskathode (2, 21, 22), welche zylinderförmige Verdampfungskathode (2, 21, 22) das Targetmaterial (200, 201, 202) umfasst, wobei weiter eine elektrische Energiequelle (7, 71, 72) zur Erzeugung einer elektrischen Spannung zwischen der Anode (6, 61) und der Kathode (2, 21, 22) vorgesehen ist, so dass mittels der elektrischen Energiequelle (7, 71, 72) das Targetmaterial (200, 201, 202) der zylinderförmigen Kathode (2, 21, 22) in eine Dampfphase überführbar ist, und eine ein Magnetfeld erzeugende Magnetfeldquelle (8, 81, 82) vorgesehen ist, wobei in der Prozesskammer (3) gleichzeitig eine Zerstäubungskathode (2, 21) und eine Lichtbogenkathode (2, 22) vorgesehen ist, **dadurch gekennzeichnet, dass** die Zerstäubungskathode (2, 21) eine zylinderförmige Zerstäubungskathode (2, 21) und die Lichtbogenkathode (2, 22) eine zylinderförmige Lichtbogenkathode (2, 22) ist und eine Position der Magnetfeldquelle (8, 81, 82) im Inneren (I) der zylinderförmigen Zerstäubungskathode (2, 21) und / oder im Inneren (I) der zylinderförmigen Lichtbogenkathode (2, 22), in Bezug auf eine Umfangsrichtung einstellbar ist, wobei ein und dieselbe Verdampfungskathode (2, 21, 22) derart ausgestaltet und in der Prozesskammer angeordnet ist, dass die Verdampfungskathode (2, 21, 22) sowohl als Zerstäubungskathode (2, 21), als auch als Lichtbogenkathode (2, 22) verwendbar ist.

2. Verdampfungsvorrichtung nach Anspruch 1, wobei die zylinderförmige Zerstäubungskathode (2, 21) und / oder die zylinderförmige Lichtbogenkathode (2, 22) um eine Längsachse (A) drehbar ausgestaltet ist.

3. Verdampfungsvorrichtung nach einem der Ansprüche 1 oder 2, wobei die Magnetfeldquelle (8, 81, 82) in einem Inneren (I) der zylinderförmigen Zerstäubungskathode (2, 21) und / oder in einem Inneren (I) der zylinderförmigen Lichtbogenkathode (2, 22) vorgesehen ist und / oder die zylinderförmige Zerstäubungskathode (2, 21) und / oder die zylinderförmige Lichtbogenkathode (2, 22) relativ zur Magnetfeldquelle (8, 81, 82) drehbar angeordnet ist.

4. Verdampfungsvorrichtung nach einem der vorangehenden Ansprüche, wobei die Magnetfeldquelle (8, 81, 82) ein Permanentmagnet (8, 81, 82) und / oder ein Elektromagnet (8, 81, 82) ist.

5. Verdampfungsvorrichtung nach einem der vorangehenden Ansprüche, wobei eine Position der Magnetfeldquelle (8, 81, 82) im Inneren (I) der zylinderförmigen Zerstäubungskathode (2, 21) und / oder im Inneren (I) der zylinderförmigen Lichtbogenkathode (2, 22), insbesondere in Bezug auf eine axiale Position und / oder eine radiale Position einstellbar ist.

6. Verdampfungsquelle nach einem der vorangehenden Ansprüche, wobei eine Stärke des Magnetfeldes der Magnetfeldquelle (8, 81, 82) steuerbar und / oder regelbar ist, wobei die Magnetfeldquelle (8, 81, 82) bevorzugt derart vorgesehen und angeordnet ist, dass in einem vorgebbaren Bereich der zylinderförmigen Verdampfungskathode (2, 21, 22) eine Magnetfeldstärke des Magnetfeldes veränderbar ist.

7. Verdampfungsquelle nach einem der vorangehenden Ansprüche, wobei als Zerstäubungskathode (2, 21) ein balanciertes Magnetron (2, 21) und / oder ein unbalanciertes Magnetron (2, 21) vorgesehen ist.

8. Verfahren zum Beschichten eines Substrats (S) in einer Prozesskammer (3), in welcher Prozesskammer (3) eine Gasatmosphäre errichtet und aufrechterhalten wird, und in der Prozesskammer (3) eine Anode (6, 61) und eine als Target (2, 21, 22) ausgestaltete zylinderförmige Verdampfungskathode (2, 21, 22) bereitgestellt wird, welche zylinderförmige Verdampfungskathode (2, 21, 22) das Targetmaterial (200, 201, 202) umfasst, und mittels einer elektrischen Energiequelle (7, 71, 72) das Targetmaterial (200, 201, 202) der zylinderförmigen Kathode (2, 21, 22) in eine Dampfphase überführt wird, wobei eine ein Magnetfeld erzeugende Magnetfeldquelle (8, 81, 82) derart in der Prozesskammer (3) vorgesehen wird, dass in einem vorgegebenen Bereich der zylinderförmigen Verdampfungskathode (2, 21, 22) eine Magnetfeldstärke des Magnetfeldes verändert werden kann, wobei in der Prozesskammer gleichzeitig eine Zerstäubungskathode (2, 21) und eine Lichtbogenkathode (2, 22) vorgesehen wird, und das Substrat (S) mit einem Lichtbogenverdampfungsverfahren und / oder einem Kathodenzerstäubungsverfahren beschichtet wird, **dadurch gekennzeichnet, dass** die Zerstäubungskathode (2, 21) eine zylinderförmige Zerstäubungskathode (2, 21) und die Lichtbogenkathode (2, 22) eine zylinderförmige Lichtbogenkathode (2, 22) ist und eine Position der Magnetfeldquelle (8, 81, 82) im Inneren (I) der zylinderförmigen Zerstäubungskathode (2, 21) und / oder im Inneren (I) der zylinderförmigen Lichtbogenkathode (2, 22), in Bezug auf eine Umfangsrichtung eingestellt wird wobei ein und dieselbe Verdampfungskathode (2, 21, 22) als Zerstäubungskathode (2, 21) und als Lichtbogenkathode (2, 22) verwendet wird.

9. Verfahren nach Anspruch 8 , wobei die zylinderförmige Verdampfungskathode (2, 21, 22) zur gleichmässigen Ausnutzung des Targetmaterials (200, 201, 202) während eines Beschichtungsvorgangs um eine Längsachse (A) rotiert wird.

10. Verfahren nach einem der Ansprüche 8 oder 9 , wobei eine Position der Magnetfeldquelle (8, 81, 82) in einem Inneren (I) der zylinderförmigen Zerstäubungskathode (2, 21) und / oder in einem Inneren (I) der zylinderförmigen Lichtbogenkathode (2, 22), insbesondere in Bezug auf eine axiale Position und / oder eine radiale Position eingestellt wird.

11. Verfahren nach einem der Ansprüche 8 bis 10 , wobei eine Stärke des Magnetfeldes der Magnetfeldquelle (8, 81, 82) gesteuert und / oder geregelt wird.

12. Verfahren nach einem der Ansprüche 8 bis 11 , wobei als Zerstäubungskathode (2, 21) ein balanciertes Magnetron (2, 21) und / oder ein unbalanciertes Magnetron (2, 21) verwendet wird.

13. Verfahren nach einem der Ansprüche 8 bis 12 , wobei das Beschichtungsverfahren ein DC-Sputterverfahren und / oder ein RF-Sputterverfahren und / oder ein gepulstes Sputterverfahren und / oder ein High-Power-Sputterverfahren und / oder ein DC-Lichtbogenverdampfungsverfahren und / oder ein gepulstes Lichtbogenverdampfungsverfahren ist.

## Claims

1. A vaporization apparatus for the vaporization of a target material (200, 201, 202), comprising a process chamber (3) for the setting up and maintenance of a gas atmosphere, having an input (4) and an outlet (5) for a process gas, as well as a anode (6, 61) and a cylindrical vaporization cathode (2, 21, 22) formed as a target (2, 21, 22), the cylindrical vaporization cathode (2, 21, 22) comprising target material (200, 201, 202), wherein in addition an electrical energy source (7, 71, 72) is provided for the generation of an electric potential between the anode (6, 61) and the cylindrical cathode (2, 21, 22) such that the target material (200, 201, 202) of the cylindrical cathode (2 ,21, 22) can be transferred into a vapor phase by means of the electrical energy source (7, 71, 72), and wherein a magnetic field source (8, 81, 82) generating a magnetic field is provided, wherein the process chamber (3) comprises simultaneously a sputtering cathode (2, 21) and an arc cathode (2, 22), **characterized in that** the sputtering cathode is a cylindrical sputtering cathode (2, 21) and the arc cathode is a cylindrical arc cathode (2, 22), wherein the position of the magnetic field source (8,81,82) in an interior (I) of the cylindrical sputtering cathode (2, 21) and/or in an interior (I) of the cylindrical arc cathode (2, 22) can be set in relation to a peripheral direction, wherein one and the same vaporization cathode (2, 21, 22) is adapted and arranged in the process chamber such that the vaporization cathode (2, 21, 22) can be used as a sputtering cathode (2, 21) and also as an arc cathode (2, 22).

2. A vaporization apparatus in accordance with claim 1, wherein the cylindrical sputtering cathode (2, 21) and / or the cylindrical arc cathode (2, 22) is adapted for rotation about a longitudinal axis (A).

3. A vaporization apparatus in accordance with one of claims 1 or 2, wherein the magnetic field source (8, 81, 82) is provided in an interior (I) of the cylindrical sputtering cathode (2, 21), and / or in an interior (I) of the cylindrical arc cathode (2, 22) and / or the cylindrical sputtering cathode (2, 21) and / or the cylindrical arc cathode (2, 22) is rotatably arranged relative to the magnetic field source (8, 81, 82).

4. A vaporization apparatus in accordance with any one of the preceding claims, wherein the magnetic field source (8, 81, 82) is a permanent magnet (8, 81, 82) and / or an electromagnet (8, 81, 82).

5. A vaporization apparatus in accordance with any one of the preceding claims, wherein a position of the magnetic field source (8, 81, 82) can be set in the interior (I) of the cylindrical sputtering cathode (2, 21) and / or in the interior (I) of the cylindrical arc cathode (2, 22), in particular in relation to an axial position and / or to a radial position.

6. A vaporization apparatus in accordance with any one of the preceding claims, wherein a strength of the magnetic field of the magnetic field source (8, 81, 82) is settable and / or controllable, wherein the magnetic field source (8, 81, 82) is preferably provided and arranged in such a way that a magnetic field strength of the magnetic field is changeable in a presetable region of the cylindrical vaporization cathode (2, 21, 22).

7. A vaporization apparatus in accordance with any one of the preceding claims, wherein a balanced magnetron (2, 21) and / or an imbalanced magnetron (2, 21) is provided as the sputtering cathode (2, 21).

8. A method for the coating of a substrate (S) in a process chamber (3), in which a gas atmosphere is set up and maintained in the process chamber (3) and an anode (6, 61) and a cylindrical vaporization cathode (2, 21, 22) formed as a target (2, 21, 22) are provided in the process chamber (3), the cylindrical vaporization cathode (2, 21, 22) includes the target material (200, 201, 202) and the target material (200, 201, 202) of the cylindrical cathode (2, 21, 22) is transferred into a vapor phase by means of an electrical source of energy (7, 71, 72), wherein a magnetic field source (8, 81, 82) generating a magnetic field is provided in the process chamber (3) in such a way that, a magnetic field strength of the magnetic field can be changed in a preset region of the cylindrical vaporization cathode (2, 21, 22), wherein a cylindrical sputtering cathode (2, 21) and a cylindrical arc cathode (2, 22) are simultaneously provided in the process chamber (3), and wherein the substrate (S) is coated with an arc vaporization process and / or with a cathode sputtering process, **characterized by** the sputtering cathode being a cylindrical sputtering cathode (2, 21) and the arc cathode being a cylindrical arc cathode (2, 22), and by setting the position of the magnetic field source (8,81,82) in an interior (I) of the cylindrical sputtering cathode (2, 21) and/or in an interior (I) of the cylindrical arc cathode (2, 22) in relation to a peripheral direction, wherein one and the same vaporization cathode (2, 21, 22) is used both as sputtering cathode (2, 21) and as arc cathode (2, 22).

9. A method in accordance with claim 8, wherein the cylindrical vaporization cathode (2, 21, 22) is rotated about a longitudinal axis (A) during a coating process for a uniform utilization of the target material (200, 201, 202).

10. A method in accordance with any one of claims 8 or 9, wherein a position of the magnetic field source (8, 81, 82), is set in an interior (I) of the cylindrical sputtering cathode (2, 21) and / or in an interior (I) of the cylindrical arc cathode (2, 22), in particular in relation to an axial position and / or a radial position.

11. A method in accordance with any one of the claims 8 to 10, wherein a strength of the magnetic field of the magnetic field source (8, 81, 82) is set and / or controlled.

12. A method in accordance with any one of the claims 8 to 11, wherein a balanced magnetron (2, 21) and / or an imbalanced magnetron (2, 21) is/are used as a sputtering cathode (2, 21).

13. A method in accordance with any one of the claims 8 to 12, wherein the coating process is a DC sputtering process and / or an RF sputtering process and / or a pulsed sputtering process and / or a high power sputtering process and / or a DC arc vaporization process and / or a pulsed arc vaporization process.

## Revendications

1. Un dispositif d'évaporation pour évaporer un matériau cible (200, 201, 202) comprenant une chambre de traitement (3) pour établir et maintenir une atmosphère de gaz ayant une entrée (4) et une sortie (5) pour un gaz de traitement, et une anode (6, 61) et une cathode d'évaporation cylindrique (2, 21, 22) conçue comme cible (2, 21, 22), laquelle cathode d'évaporation cylindrique (2, 21, 22) comprend le matériau cible (200, 201, 202), dans lequel en outre une source d'énergie électrique (7, 71, 72) est prévue pour générer une tension électrique entre l'anode (6, 61) et la cathode (2, 21, 22) de sorte que le matériau cible (200, 201, 202) de la cathode cylindrique (2, 21, 22) peut être transformée en phase vapeur au moyen de la source d'énergie électrique (7, 71, 72), et une source de champ magnétique (8, 81, 82) générant un champ magnétique est prévue, dans lequel une cathode de pulvérisation (2, 21) et une cathode à arc (2, 22) sont prévues simultanément dans la chambre de traitement (3), **caractérisé en ce que** la cathode de pulvérisation (2, 21) est une cathode de pulvérisation cylindrique (2, 21) et la cathode à arc (2, 22) est une cathode à arc cylindrique (2, 22), et une position de la source de champ magnétique (8, 81, 82) peut être réglée à l'intérieur (I) de la cathode de pulvérisation cylindrique (2, 21) et / ou à l'intérieur (I) de la cathode à arc cylindrique (2, 22) par rapport à une direction périphérique, dans lequel une seule et même cathode d'évaporation (2, 21, 22) est conçue et disposée dans la chambre de traitement de telle sorte que la cathode d'évaporation (2, 21, 22) peut être utilisée à la fois comme cathode de pulvérisation (2, 21) et comme cathode à arc (2, 22).

2. Un dispositif d'évaporation selon la revendication 1, dans lequel la cathode de pulvérisation cylindrique (2, 21) et / ou la cathode à arc cylindrique (2, 22) est conçue pour tourner autour d'un axe longitudinal (A).

3. Un dispositif d'évaporation selon l'une des revendications 1 ou 2, dans lequel la source de champ magnétique (8, 81, 82) est prévue dans un intérieur (I) de la cathode de pulvérisation cylindrique (2, 21) et / ou dans un intérieur (I) de la cathode à arc cylindrique (2, 22) et / ou la cathode de pulvérisation cylindrique (2, 21) et / ou la cathode à arc cylindrique (2, 22) est disposée rotative par rapport à la source de champ magnétique (8, 81, 82).

4. Un dispositif d'évaporation selon l'une des revendications précédentes, dans lequel la source de champ magnétique (8, 81, 82) est un aimant permanent (8, 81, 82) et / ou un électroaimant (8, 81, 82).

5. Un dispositif d'évaporation selon l'une des revendications précédentes, dans lequel une position de la source de champ magnétique (8, 81, 82) peut être réglée à l'intérieur (I) de la cathode de pulvérisation cylindrique (2, 21) et / ou à l'intérieur (I) de la cathode à arc cylindrique (2, 22), en particulier par rapport à une position axiale et / ou une position radiale.

6. Une source d'évaporation selon l'une des revendications précédentes, dans laquelle une intensité du champ magnétique de la source de champ magnétique (8, 81, 82) peut être commandée et / ou régulée, dans laquelle la source de champ magnétique (8, 81, 82) est de préférence prévue et disposée de telle sorte qu'une intensité de champ magnétique du champ magnétique peut être modifiée dans une région pré-déterminable de la cathode d'évaporation cylindrique (2, 21, 22).

7. Une source d'évaporation selon l'une des revendications précédentes, dans laquelle un magnétron équilibré (2, 21) et / ou un magnétron non équilibré (2, 21) est prévu comme cathode de pulvérisation (2, 21).

8. Un procédé de revêtement d'un substrat (S) dans une chambre de traitement (3), dans quelle chambre de traitement (3) une atmosphère de gaz est établie et maintenue, et une anode (6, 61) et une cathode d'évaporation cylindrique (2, 21, 22) conçue comme cible (2, 21, 22) sont prévues dans la chambre de traitement (3), laquelle cathode d'évaporation cylindrique (2, 21, 22) comprend le matériau cible (200, 201, 202), et le matériau cible (200, 201, 202) de la cathode cylindrique (2, 21, 22) est transformé en une phase vapeur au moyen d'une source d'énergie électrique (7, 71, 72), dans lequel une source de champ magnétique (8, 81, 82) générant un champ magnétique est prévue dans la chambre de traitement (3) de telle sorte qu'une intensité de champ magnétique du champ magnétique peut être modifiée dans une région prédéterminée de la cathode d'évaporation cylindrique (2, 21, 22), dans lequel une cathode de pulvérisation (2, 21) et une cathode à arc (2, 22) sont prévues simultanément dans la chambre de traitement, et le substrat (S) est revêtu d'un procédé d'évaporation à l'arc et / ou d'un procédé de pulvérisation cathodique, **caractérisé en ce que** la cathode de pulvérisation (2, 21) est une cathode de pulvérisation cylindrique (2, 21) et la cathode à arc (2, 22) est une cathode à arc cylindrique (2, 22) et une position de la source de champ magnétique (8, 81, 82) est réglée à l'intérieur (I) de la cathode de pulvérisation cylindrique (2, 21) et / ou à l'intérieur (I) de la cathode à arc cylindrique (2, 22) par rapport à une direction périphérique, dans lequel une seule et même cathode d'évaporation (2, 21, 22) est utilisée comme cathode de pulvérisation (2, 21) et comme cathode à arc (2, 22).

9. Un procédé selon la revendication 8, dans lequel la cathode d'évaporation cylindrique (2, 21, 22) est tournée autour d'un axe longitudinal (A) pour une utilisation uniforme du matériau cible (200, 201, 202) pendant un processus de revêtement.

10. Un procédé selon l'une des revendications 8 ou 9, dans lequel une position de la source de champ magnétique (8, 81, 82) est réglée dans un intérieur (I) de la cathode de pulvérisation cylindrique (2, 21) et / ou dans un intérieur (I) de la cathode à arc cylindrique (2, 22), en particulier par rapport à une position axiale et / ou une position radiale.

11. Un procédé selon l'une des revendications 8 à 10, dans lequel une intensité du champ magnétique de la source de champ magnétique (8, 81, 82) est commandée et / ou régulée.

12. Un procédé selon l'une des revendications 8 à 11, dans lequel un magnétron équilibré (2, 21) et / ou un magnétron non équilibré (2, 21) est utilisé comme cathode de pulvérisation (2, 21).

13. Un procédé selon l'une des revendications 8 à 12, dans lequel le procédé de revêtement est un procédé de pulvérisation DC et / ou un procédé de pulvérisation RF et / ou un procédé de pulvérisation pulsée et / ou un procédé de pulvérisation de haute puissance et / ou un procédé d'évaporation à arc DC et / ou un procédé d'évaporation à arc pulsé.
